# EUROPEAN PATENT APPLICATION

(11) **EP 4 438 768 A1**
(43) Date of publication of application: **02.10.2024**
(21) Application number: 24164762.7
(22) Date of filing: 20.03.2024
(51) Int. Cl.: C23C 16/44, C23C 16/455, C23C 16/458

(54) **FILM FORMING APPARATUS AND METHOD OF MANUFACTURING ORGANIC LIGHT EMITTING APPARATUS**

(30) Priority: 28.03.2023 JP 2023051989
(71) Applicant: CANON KABUSHIKI KAISHA, Tokyo 146-8501 (JP)
(72) Inventor: ISHII, Ryuji, Tokyo (JP)
(74) Representative: WESER & Kollegen Patentanwälte PartmbB

(57) **Abstract**

A film forming apparatus includes an outer chamber, an inner chamber arranged inside the outer chamber and dividable into a first portion and a second portion, a driving mechanism configured to lift and lower the second portion along an elevator axis, and a plurality of supply paths arranged so as to be capable of individually supplying a plurality of source gases to a first space which is a space inside the inner chamber. The first portion includes a first seal, and the second portion includes a second seal to come into contact with the first seal. In a longitudinal section along a plane including the elevator axis, a surface of each of the first seal and the second seal has a non-linear shape.

## Description

### BACKGROUND OF THE INVENTION

### Field of the Invention

The present invention relates to a film forming apparatus, and a method of manufacturing an organic light emitting apparatus.

### Description of the Related Art

As an example of a method of forming various thin films on a processing target object by alternately supplying a plurality of source gases in a reaction chamber, an Atomic Layer Deposition (ALD) method has been known. In the ALD method, a second source gas is supplied onto a processing target object in a state in which a first source gas has adsorbed to the processing target object. With this, the first source gas and the second source gas come into contact and react, thereby forming a desired thin film. At this time, operations of making a source gas adsorb to the processing target object and then discharging the unadsorbed source gas from the chamber, and supplying another source gas to the chamber to let it react with the source gas on the processing target chamber and then discharging the unreacted other source gas from the chamber are repeated. The material of the source gas can be used in any of solid, liquid, and gaseous states. In general, the source gas is supplied to the chamber together with a carrier gas consisting of an inert gas such as nitrogen or argon.

As a vacuum film forming apparatus that forms a film by the ALD method, an apparatus has been known that includes a double structure chamber including an inner chamber, where a film is formed on a substrate by alternately supplying a plurality of source gases, and an outer chamber surrounding the inner chamber. Japanese Patent Laid-Open No. 2012-184482 describes a double structure chamber including an inner chamber formed by a top plate and a bottom wall that can be separated from each other, and an outer chamber surrounding the inner chamber. Japanese Patent Laid-Open No. 2012-184482 does not specify the arrangement of the seal portions of the top plate and the bottom wall.

In the film forming apparatus including the double structure chamber, since the pressure in the inner space of the inner chamber is higher than the pressure in the outer space of the inner chamber (the inner space of the outer chamber), the source gas can leak from the inner space of the inner chamber to the outer space thereof through the seal portion of the inner chamber. Therefore, the source gas leaking to the outer space through the seal portion can generate a foreign substance. Such a foreign substance can adhere to the substrate during conveying the substrate, resulting in a defective product.

### SUMMARY OF THE INVENTION

The present invention provides a technique advantageous in reducing leakage of a gas from the inner space of an inner chamber to the outer space thereof.

The present invention in its first aspect provides a film forming apparatus as specified in claims 1 to 14.

The present invention in its second aspect provides a method of manufacturing an electronic device as specified in claims 15 and 16.

Further features of the present invention will become apparent from the following description of exemplary embodiments with reference to the attached drawings.

### BRIEF DESCRIPTION OF THE DRAWINGS

Fig. 1 is a sectional view schematically showing the arrangement of a film forming apparatus according to an embodiment;
Fig. 2 is a top view showing a second portion and a second seal;
Fig. 3 is a bottom view showing a first portion and a first seal;
Fig. 4 is a sectional view schematically showing the arrangement of the film forming apparatus according to the embodiment;
Fig. 5 is a sectional view schematically showing the arrangement of a film forming apparatus of a comparative example;
Fig. 6 is a sectional view schematically showing a seal mechanism in the film forming apparatus of the comparative example;
Fig. 7A is a sectional view schematically showing the arrangement of a seal mechanism of Example 1 in a film forming apparatus according to the embodiment;
Fig. 7B is a sectional view schematically showing the arrangement of the seal mechanism of Example 2 in the film forming apparatus according to the embodiment;
Fig. 7C is a sectional view schematically showing the arrangement of the seal mechanism of Example 3 in the film forming apparatus according to the embodiment;
Fig. 7D is a sectional view schematically showing the arrangement of the seal mechanism of Example 4 in the film forming apparatus according to the embodiment;
Fig. 7E is a sectional view schematically showing the arrangement of the seal mechanism of Example 5 in the film forming apparatus according to the embodiment;
Fig. 7F is a sectional view schematically showing the arrangement of the seal mechanism of Example 6 in the film forming apparatus according to the embodiment;
Fig. 7G is a sectional view schematically showing the arrangement of the seal mechanism of Example 7 in the film forming apparatus according to the embodiment;
Fig. 8 is a plan view showing an example of the configuration of a processing system including the film forming apparatus;
Figs. 9A and 9B are views for explaining a display apparatus;
Fig. 10 is a view showing an example of the arrangement of a display apparatus;
Fig. 11A is a view showing an example of the arrangement of an image capturing apparatus;
Fig. 11B is a view showing an example of the arrangement of electronic equipment;
Figs. 12A and 12B are views showing two examples of the arrangement of a display apparatus;
Fig. 13A is a view showing an example of the arrangement of an illumination apparatus;
Fig. 13B is a view showing an example of the arrangement of a moving body;
Figs. 14A and 14B are views showing two examples of the arrangement of a wearable device; and
Figs. 15A to 15C are views showing examples of the arrangement of an image forming apparatus.

### DESCRIPTION OF THE EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

In this specification and drawings, directions will be described in accordance with X, Y, and Z coordinates. Typically, a Z-axis is a direction parallel to a vertical direction, and an X-Y plane is a horizontal plane.

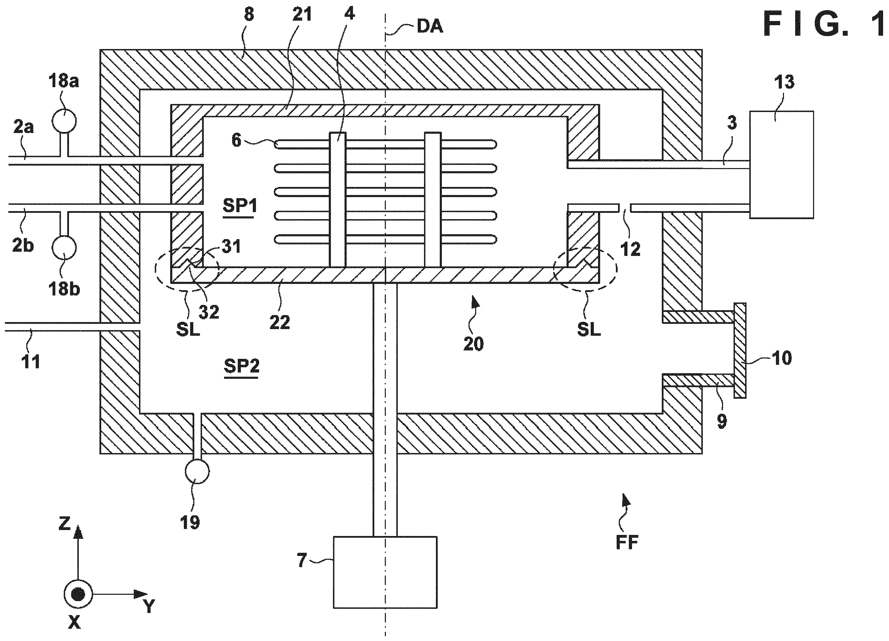

Fig. 1 is a sectional view schematically showing the arrangement of a film forming apparatus FF according to an embodiment of the present disclosure. The film forming apparatus FF can be formed as an apparatus that forms a film on a substrate 6, for example, an apparatus that forms a film on the substrate 6 by an atomic layer deposition method. The film forming apparatus FF can include an outer chamber 8, and an inner chamber 20 arranged inside the outer chamber 8. The inner chamber 20 is formed to be dividable into a first portion 21 and a second portion 22. The first portion 21 may be arranged above the second portion 22, or may be arranged below the second portion 22. In the example shown in Fig. 1, the first portion 21 is arranged above the second portion 22. The film forming apparatus FF can further include a driving mechanism 7 that lifts and lowers the second portion 22 along an elevator axis DA. The elevator axis DA is a virtual axis.

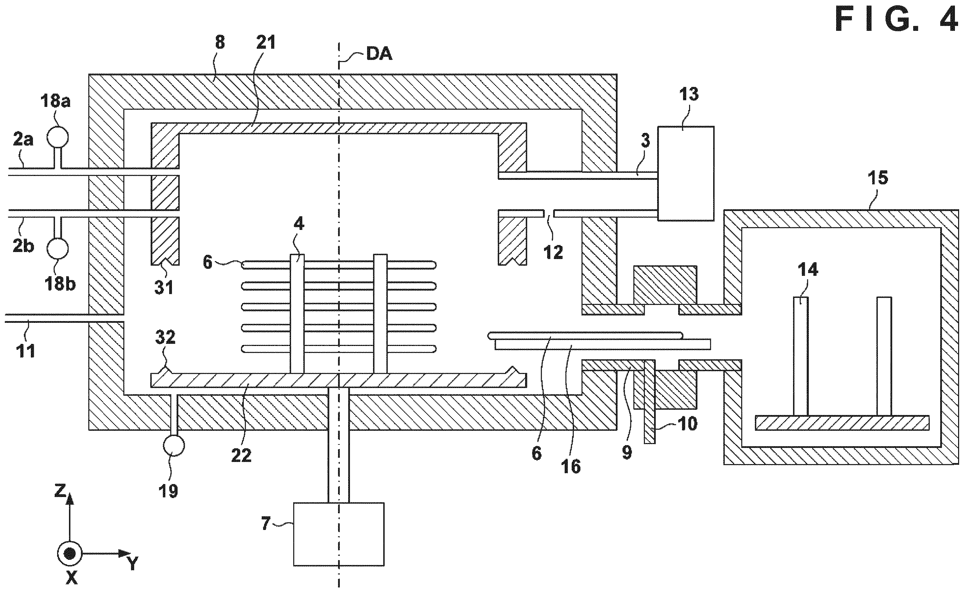

The first portion 21 can include a first seal 31, and the second portion 22 can include a second seal 32 to come into contact with the first seal 31. The driving mechanism 7 is configured to be capable of driving the second portion 22 to a first position where a first state is set, in which the first seal 31 and the second seal 32 are in contact with each other, and driving the second portion 22 to a second position where a second state is set, in which the first seal 31 and the second seal 32 are separated from each other. The first state is the state shown in Fig. 1, and the second state is the state shown in Fig. 4.

The first seal 31 and the second seal 32 can form a seal mechanism SL that insulates a second space SP2, which is a space inside the outer chamber 8 and outside the inner chamber 20, from a first space SP1 in the first state in which the first seal 31 and the second seal 32 are in contact with each other. In a longitudinal section along a plane including the elevator axis DA, for example, in Fig. 1, the surface of each of the first seal 31 and the second seal 32 can have a non-linear shape. Such an arrangement is effective in preventing or reducing leakage of a source gas from the first space SP1 to the second space SP2 in the first state.

In the longitudinal section along the plane including the elevator axis DA, one of the first seal 31 and the second seal 32 can include a concave shape part, and the other of the first seal 31 and the second seal 32 can include a convex shape part. In the longitudinal section, one of the first seal 31 and the second seal 32 may include a plurality of concave shape parts, and the other of the first seal 31 and the second seal 32 may include a plurality of convex shape parts. Alternatively, in the longitudinal section, one of the first seal 31 and the second seal 32 may include a first concave part and a first convex part, and the other of the first seal 31 and the second seal 32 may include a second convex part facing the first concave part, and a second concave part facing the first convex part.

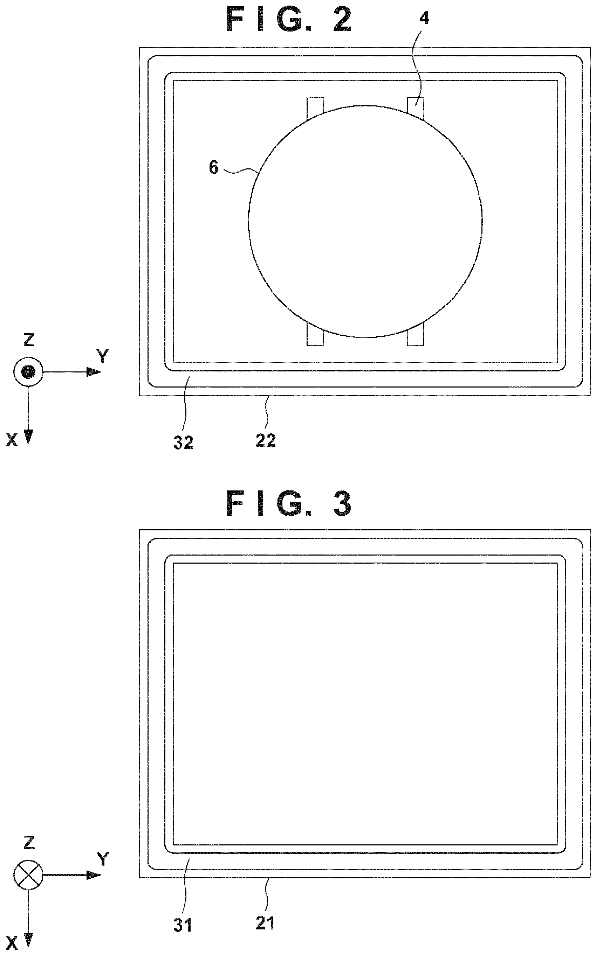

Fig. 2 is a top view showing the second portion 22 and the second seal 32 when viewed from above. Fig. 3 is a bottom view showing the first portion 21 and the first seal 31 when viewed from below. As exemplarily shown in Figs. 2 and 3, each of the first seal 31 and the second seal 32 can have a frame shape in a transverse section along a plane orthogonal to the elevator axis DA. The frame shape may be understood to be a shape forming a closed shape. In the first state in which the driving mechanism 7 has driven the second portion 22 to bring the first seal 31 and the second seal 32 into contact with each other, the first seal 31 and the second seal 32 can be in line contact with each other. Such an arrangement is effective in increasing the contact pressure between the first seal 31 and the second seal 32, thereby preventing or reducing leakage of the source gas from the first space SP1 to the second space SP2. In the first state in which the first seal 31 and the second seal 32 are in contact with each other, the contact portion between the first seal 31 and the second seal 32 can form a closed shape.

The film forming apparatus FF can include a plurality of supply paths 2a and 2b arranged so as to be capable of individually supplying a plurality of source gases to the first space SP1 which is a space inside the inner chamber 20. The plurality of supply paths 2a and 2b can be provided with pressure gauges 18a and 18b, respectively. The film forming apparatus FF can be configured to alternately supply the plurality of source gases to the first space SP1 through the plurality of supply paths 2a and 2b. The film forming apparatus FF can include one or a plurality of supply paths 11 arranged so as to be capable of supplying a gas to the second space SP2 which is a space inside the outer chamber 8 and outside the inner chamber 20. The one or plurality of supply paths 11 can be used to, for example, adjust the pressure in the second space SP2.

The film forming apparatus FF can include a substrate holder 4 that holds one or a plurality of substrates 6. The substrate holder 4 can be supported by the second portion 22. When the second portion 22 is lifted/lowered by the driving mechanism 7, the one or plurality of substrates 6 held by the substrate holder 4 can also be lifted/lowered. The film forming apparatus FF can include an exhaust pipe 3 and a vacuum pump 13 forming an exhaust path for exhausting the gases in the first space SP1 and the second space SP2. In an example, the exhaust pipe 3 can be provided with a communication hole 12 that communicates the exhaust path with the second space SP2. The film forming apparatus FF can include a conveyance port 9 for conveying the substrate 6 to the substrate holder 4 from the outer space of the outer chamber 8 and conveying the substrate 6 to the outer space of the outer chamber 8 from the substrate holder 4, and a gate valve 10 for opening/closing the conveyance port 9. As schematically shown in Fig. 4, the film forming apparatus FF can include a conveying mechanism 16 that conveys the substrate 6 from the outer space (for example, a load lock chamber 15) of the outer chamber 8 to the inner space of the outer chamber 8 and conveys the substrate 6 from the inner space of the outer chamber 8 to the outer space thereof. The film forming apparatus FF can include a pressure gauge 19 for measuring the pressure in the second space SP2.

### <First Embodiment>

With reference to Figs. 1 and 4, one operation sequence of a film forming apparatus FF in the first embodiment will be exemplarily described below. First, a substrate 6 (wafer) is conveyed from a wafer cassette (not shown) to a substrate holder 14 in a load lock chamber 15 by a conveyance robot (not shown). After the pressure inside the load lock chamber 15 is evacuated to 5 Pa or less, a gate valve 10 is opened, and a conveying mechanism 16 conveys the substrate 6 from the substrate holder 14 to a substrate holder 4. Such conveyance is repeated until the substrate holder 4 is filled with a predetermined number of the substrates 6.

After the filling operation of the substrate holder 4 with the substrates 6 is completed, the gate valve 10 is closed, and a driving mechanism 7 drives a second portion 22 upward so as to bring a second seal 32 into contact with a first seal 31, thereby closing an inner chamber 20. Then, while monitoring the pressure in a first space SP1 by a pressure gauge 18a, N₂ gas is supplied to the first space SP1 through a supply path 2a while adjusting the flow rate of the N₂ gas passing through the supply path 2a to set the pressure in the first space SP1 to 30 hPa. In addition, while monitoring the pressure in a second space SP2 by a pressure gauge 19, the flow rate of N₂ gas passing through a supply path 11 is adjusted to set the pressure in the second space SP2 to 3 hPa.

After waiting until the temperature of the first space SP1 inside the inner chamber 20 reaches the set temperature, a first source gas is supplied to the first space SP1 through the supply path 2a so as to adsorb to the substrate 6, and the unadsorbed first source gas is discharged through an exhaust pipe 3. Then, a second source gas is supplied to the first space SP1 through a supply path 2b to let the second source gas react with the first source gas adsorbed to the substrate 6, and the unreacted second source gas is discharged through the exhaust pipe 3. By repeating supply of the first source gas and supply of the second source gas as described above, a film having a target thickness is formed on the substrate 6.

After that, the driving mechanism 7 drives the second portion 22 downward up to a position where the conveying mechanism 16 can convey the substrate 6, the gate valve 10 is opened, and the conveying mechanism 16 conveys all the substrates 6 from the substrate holder 4 to the substrate holder 14. After that, the gate valve 10 is closed. Then, a conveyance robot (not shown) conveys the substrates 6 from the substrate holder 14 in the load lock chamber 15 to the wafer cassette.

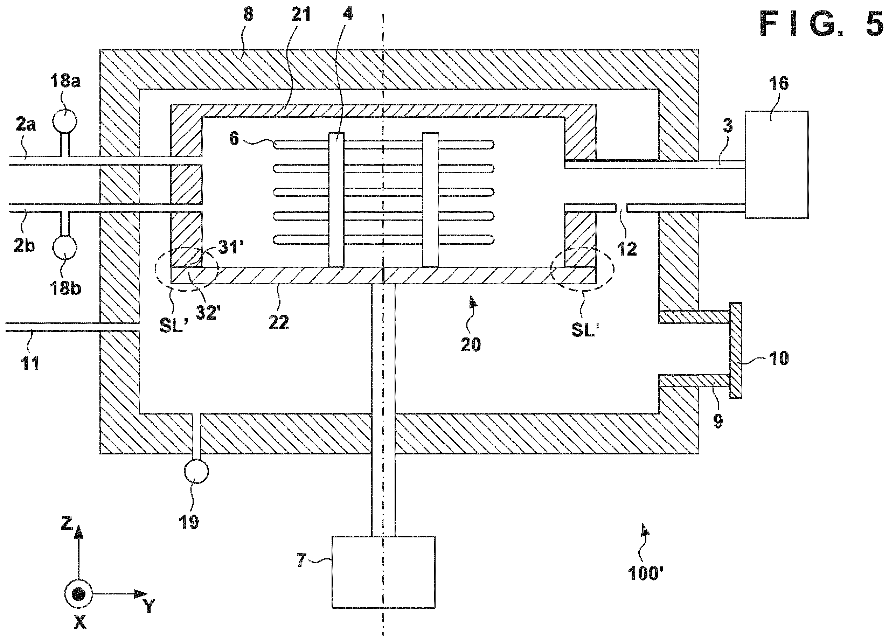

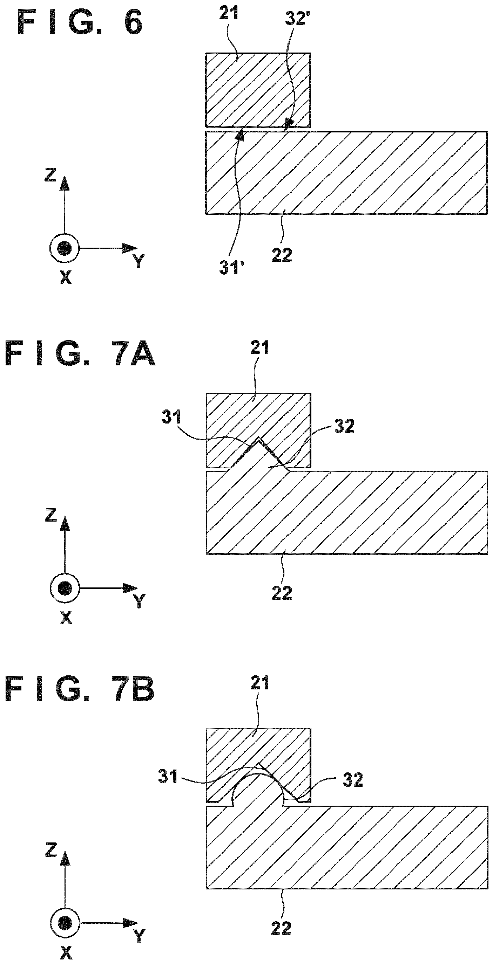

Figs. 5 and 6 show the arrangement of a film forming apparatus FF' of a comparative example. The film forming apparatus FF' of the comparative example has the arrangement obtained by replacing the first seal 31 and the second seal 32 in the film forming apparatus FF according to the embodiment with a first seal 31' and a second seal 32', respectively. The surface of each of the first seal 31' and the second seal 32' is formed by a flat surface. In other words, in a longitudinal section along a plane including an elevator axis DA, for example, in Fig. 5, the surface of each of the first seal 31' and the second seal 32' has a linear shape.

Comparative Example 1 and Examples 1 to 8 in the operation sequence according to the first embodiment will be described below.

### (Comparative Example 1)

After repeating the above-described operation sequence 15 times while using the film forming apparatus FF' of the comparative example shown in Figs. 5 and 6, foreign substances on the substrate 6 were checked by a foreign substance inspection device. As a result, 231 foreign substances of 1 µm or more were confirmed.

### (Example 1)

Fig. 7A shows the first seal 31 and the second seal 32 of Example 1. In Example 1, the first seal 31 includes a concave shape part, and the second seal 32 includes a convex shape part. More specifically, in Example 1, in the longitudinal section along the plane including the elevator axis DA, the concave shape part of the first seal 31 is formed as a triangular notch, and the convex shape part of the second seal 32 has a triangular shape.

After repeating the above-described operation sequence 15 times while using the film forming apparatus FF, foreign substances on the substrate 6 were checked by the foreign substance inspection device. As a result, 15 foreign substances of 1 µm or more were confirmed.

### (Example 2)

Fig. 7B shows the first seal 31 and the second seal 32 of Example 2. In Example 2, the first seal 31 includes a concave shape part, and the second seal 32 includes a convex shape part. More specifically, in Example 2, in the longitudinal section along the plane including the elevator axis DA, the concave shape part of the first seal 31 is formed as a triangular notch, and the convex shape part of the second seal 32 includes a portion formed by a part of a circle or ellipse.

After repeating the above-described operation sequence 15 times while using the film forming apparatus FF, foreign substances on the substrate 6 were checked by the foreign substance inspection device. As a result, 10 foreign substances of 1 µm or more were confirmed.

### (Example 3)

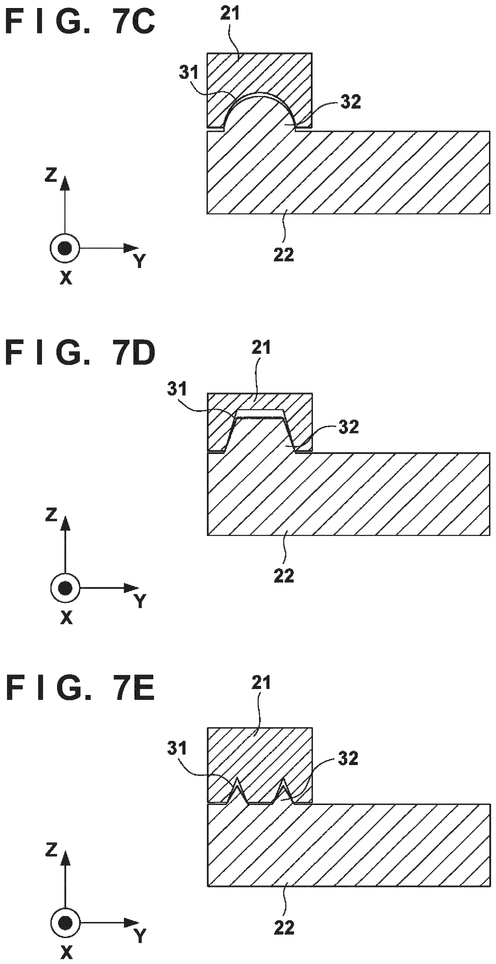

Fig. 7C shows the first seal 31 and the second seal 32 of Example 3. In Example 3, the first seal 31 includes a concave shape part, and the second seal 32 includes a convex shape part. More specifically, in Example 3, in the longitudinal section along the plane including the elevator axis DA, the concave shape part of the first seal 31 includes a portion formed by a part of a circle or ellipse, and the convex shape part of the second seal 32 includes a portion formed by a part of a circle or ellipse.

After repeating the above-described operation sequence 15 times while using the film forming apparatus FF, foreign substances on the substrate 6 were checked by the foreign substance inspection device. As a result, 11 foreign substances of 1 µm or more were confirmed.

### (Example 4)

Fig. 7D shows the first seal 31 and the second seal 32 of Example 4. In Example 4, the first seal 31 includes a concave shape part, and the second seal 32 includes a convex shape part. More specifically, in Example 4, in the longitudinal section along the plane including the elevator axis DA, the concave shape part of the first seal 31 is formed as a trapezoidal notch, and the convex shape part of the second seal 32 has a trapezoidal shape.

After repeating the above-described operation sequence 15 times while using the film forming apparatus FF, foreign substances on the substrate 6 were checked by the foreign substance inspection device. As a result, 14 foreign substances of 1 µm or more were confirmed.

### (Example 5)

Fig. 7E shows the first seal 31 and the second seal 32 of Example 5. In Example 5, the first seal 31 includes a plurality of concave shape parts, and the second seal 32 includes a plurality of convex shape parts. More specifically, in Example 5, in the longitudinal section along the plane including the elevator axis DA, each concave shape part of the first seal 31 is formed as a triangular notch, and each convex shape part of the second seal 32 includes a triangular shape.

After repeating the above-described operation sequence 15 times while using the film forming apparatus FF, foreign substances on the substrate 6 were checked by the foreign substance inspection device. As a result, 8 foreign substances of 1 µm or more were confirmed.

### (Example 6)

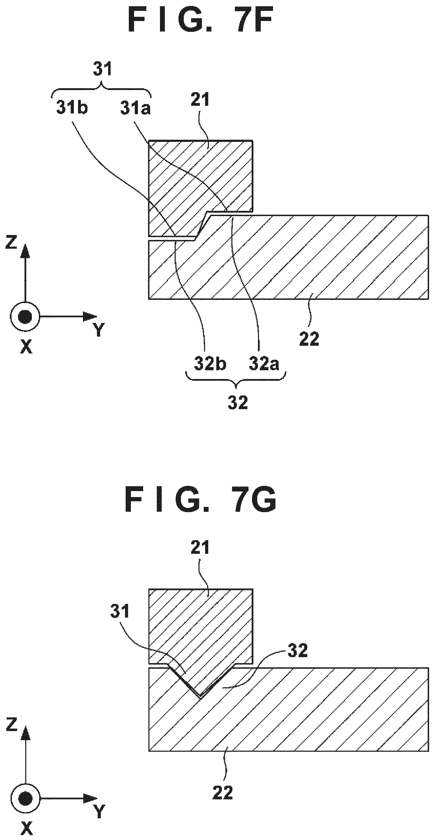

Fig. 7F shows the first seal 31 and the second seal 32 of Example 6. The first seal 31 includes a first concave part 31a and a first convex part 31b, and the second seal 32 includes a second convex part 32a facing the first concave part 31a, and a second concave part 32b facing the first convex part 31b.

After repeating the above-described operation sequence 15 times while using the film forming apparatus FF, foreign substances on the substrate 6 were checked by the foreign substance inspection device. As a result, 11 foreign substances of 1 µm or more were confirmed.

### (Example 7)

Fig. 7G shows the first seal 31 and the second seal 32 of Example 7. In Example 7, the first seal 31 includes a convex shape part, and the second seal 32 includes a concave shape part. More specifically, in Example 7, in the longitudinal section along the plane including the elevator axis DA, the convex shape part of the first seal 31 has a triangular shape, and the concave shape part of the second seal 32 is formed as a triangular notch.

After repeating the above-described operation sequence 15 times while using the film forming apparatus FF, foreign substances on the substrate 6 were checked by the foreign substance inspection device. As a result, 9 foreign substances of 1 µm or more were confirmed.

### (Example 8)

In a seal mechanism SL formed by the first seal 31 and the second seal 32, the sealing performance can deteriorate if the thickness of a film deposited on the first seal 31 and the second seal 32 increases by repeating film formation. To prevent this, after performing the film forming process many times using the film forming apparatus FF including the first seal 31 and the second seal 32 similar to those of Example 1, the first portion 21 and the second portion 22 were subjected to a film removing process using glass bead blasting and cleaning with ultrapure water. With this, the first seal 31 and the second seal 32 were regenerated. Then, after repeating the above-described operation sequence 15 times while using the film forming apparatus FF with the regenerated first seal 31 and second seal 32, foreign substances on the substrate 6 were checked by the foreign substance inspection device. As a result, 12 foreign substances of 1 µm or more were confirmed.

### (Evaluation Results)

From the results described above, the effectiveness of the arrangement, in which the surface of each of the first seal 31 and the second seal 32 has a non-linear shape in the longitudinal section, was confirmed.

### <Second Embodiment>

The second embodiment is similar to the first embodiment except that pressure control in a first space SP1 and a second space SP2 in the operation sequence in the first embodiment is changed as described below.

### <Changes>

After the filling operation of a substrate holder 4 with substrates 6 is completed, a gate valve 10 is closed, and a driving mechanism 7 drives a second portion 22 upward so as to bring a second seal 32 into contact with a first seal 31, thereby closing an inner chamber 20. Then, while monitoring the pressure in the first space SP1 by a pressure gauge 18a, N₂ gas is supplied to the first space SP1 through a supply path 2a while adjusting the flow rate of the N₂ gas passing through the supply path 2a to set the pressure in the first space SP1 to 10 hPa. In addition, while monitoring the pressure in the second space SP2 by a pressure gauge 19, the flow rate of N₂ gas passing through a supply path 11 is adjusted to set the pressure in the second space SP2 to 15 hPa. That is, in the second embodiment, the pressure in the second space SP2 is higher than the pressure in the first space SP1.

Comparative Example 2 and Example 9 in the operation sequence according to the first embodiment will be described below.

### (Comparative Example 2)

After repeating the above-described operation sequence 15 times while using the film forming apparatus FF' of the comparative example shown in Figs. 5 and 6, foreign substances on the substrate 6 were checked by a foreign substance inspection device. As a result, 342 foreign substances of 1 µm or more were confirmed. Further, 1σ of each of the in-plane distribution and inter-plane distribution of the film formed by an atomic layer deposition method was 13.2% or less.

### (Example 9)

As in Example 1, the first seal 31 and the second seal 32 shown in Fig. 7A were used. After repeating the above-described operation sequence 15 times while using a film forming apparatus FF, foreign substances on the substrate 6 were checked by the foreign substance inspection device. As a result, 16 foreign substances of 1 µm or more were confirmed. Further, 1σ of each of the in-plane distribution and inter-plane distribution of the film formed by the Atomic Layer Deposition method was 1.2% or less.

From the results described above, the effectiveness of the arrangement, in which the surface of each of the first seal 31 and the second seal 32 has a non-linear shape in the longitudinal section, was confirmed.

### <Application Examples>

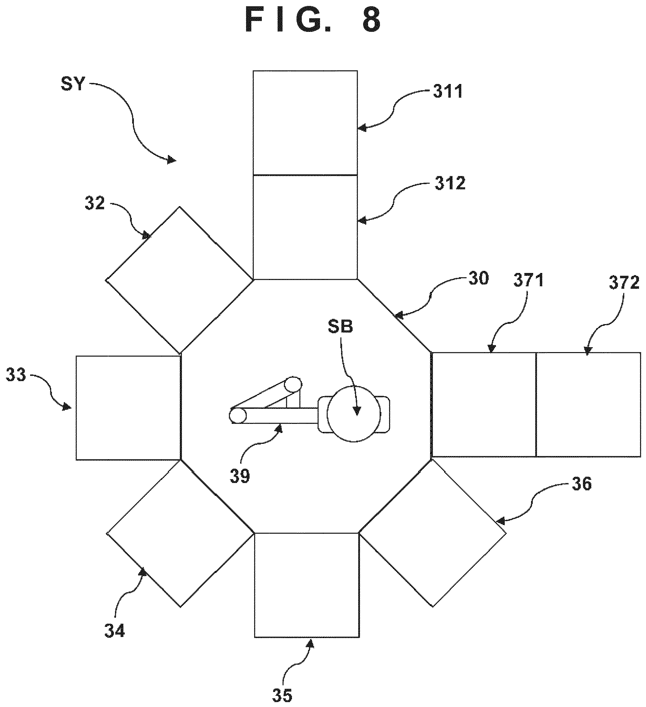

Fig. 8 shows an example of the configuration of a processing system SY including the film forming apparatus FF. The system SY can be used to manufacture an organic Electro-Luminescence (EL) device (organic light emitting device) as an example of an electronic device. The processing system SY has a cluster type configuration in which a plurality of chambers are arranged around a vacuum chamber 30. The system SY can include, for example, a loader 311, a load lock chamber 312, a plurality of processing chambers 32 to 36, a load lock chamber 371, an unloader 372, and a conveying mechanism 39.

The conveying mechanism 39 is a robot arm provided in the vacuum chamber 30. The conveying mechanism 39 sequentially conveys a substrate SB, supplied from the loader 311 through the load lock chamber 312, to the processing chambers 32 to 36. After predetermined processes are performed with respect to the substrate SB in the respective processing chambers 32 to 36, the conveying mechanism 39 conveys the substrate SB to the load lock chamber 371. The substrate SB conveyed to the load lock chamber 371 is delivered via the unloader 372. This configuration can perform a series of processes for manufacturing an organic EL device with respect to the substrate SB without making the substrate SB be exposed to the atmosphere (for example, moisture, oxygen, or the like) in the time interval from the supply of the substrate SB from the loader 311 to the delivery of the substrate SB from the unloader 372.

The processing chamber 32 is an inversion chamber (to be also referred to as the "inversion chamber 32" hereinafter) that can vertically invert the posture of the substrate SB conveyed by the conveying mechanism 39.

The processing chamber 33 is a vapor deposition chamber (to be also referred to as the "organic film vapor deposition chamber 33" hereinafter) for forming an organic compound film on the substrate SB by a vapor deposition method. An organic compound film includes a plurality of layers forming an organic light emitting device, for example, a light emitting layer (recombination layer), an electron injection layer, an electron transport layer, a hole injection layer, and a hole transport layer.

The processing chamber 34 is a vapor deposition chamber (to be also referred to as the "electrode film vapor deposition chamber 34" hereinafter) for forming an electrode film on the substrate SB by a vapor deposition method. The electrode film can be formed by, for example, a translucent or non-translucent conductive material (for example, a metal such as copper or aluminum (Al), an alloy such as a silver (Ag) alloy or magnesium (Mg) alloy, or a transparent metal such as indium tin oxide).

The processing chamber 35 is a CVD chamber (to be also referred to as the "CVD chamber 35" hereinafter) for forming a functional film on the substrate SB by CVD. Examples of the functional film can include insulating films such as a silicon nitride film and a silicon oxynitride film. As an example, a silicon nitride film can be formed by plasma CVD using silane, hydrogen, and nitrogen as source gases.

The processing chamber 36 is an ALD chamber (to be referred to as the "ALD chamber 36" hereinafter) for forming a functional film on the substrate SB by ALD. Examples of this functional film can include, for example, insulating films such as an aluminum oxide film and a titanium oxide film.

The above-described film forming apparatus FF can be employed as the ALD chamber 36. The ALD chamber 36 corresponds to the outer chamber 8 of the film forming apparatus FF, and the conveying mechanism 39 corresponds to the conveying mechanism 16.

For example, as the substrate SB, a silicon wafer on which a driving circuit (for example, a plurality of switch elements such as MOS transistors and a wiring portion connecting them) for driving an organic light emitting device has been formed can be prepared. The conveying mechanism 39 supplies the substrate SB from the loader 311 into the vacuum chamber 30 via the load lock chamber 312 and then conveys the substrate SB to the inversion chamber 32. The substrate SB is set in a desired posture in the inversion chamber 32. The conveying mechanism 39 then conveys the substrate SB to the organic film vapor deposition chamber 33 to perform a film forming process for an organic compound film.

The conveying mechanism 39 then conveys the substrate SB to the electrode film vapor deposition chamber 34 to perform a film forming process for an electrode film. The conveying mechanism 39 conveys the substrate SB to the inversion chamber 32 to vertically invert the posture of the substrate SB, and then conveys the substrate SB to the CVD chamber 35 to perform a film forming process for a functional film. Thereafter, the conveying mechanism 39 conveys the substrate SB to the ALD chamber 36 to perform a film forming process for another functional film.

Collaterally, the conveying mechanism 39 may convey the substrate SB to the CVD chamber 35 again to perform a film forming process for still another functional film.

Upon completion of the series of processes with respect to the substrate SB, the conveying mechanism 39 conveys the substrate SB to the load lock chamber 371. The conveying mechanism 39 then transmits the substrate SB from the unloader 372 to outside the processing system SY, and conveys the substrate SB to the next step. An organic EL device is manufactured by this procedure. The processing system SY may be expressed as a film forming apparatus, a manufacturing apparatus, a processing apparatus, or the like in a broad sense.

This application example has exemplified the aspect in which an organic EL device is manufactured as an example of an electronic device. However, the contents of the above embodiment can be applied to manufacture various electronic devices. In the system SY further including a plurality of chambers for sequentially processing the substrate SB, the plurality of chambers are configured so as not to make the substrate SB be exposed to the atmosphere until the completion of processes with respect to the substrate SB in the respective chambers. This makes it possible to perform a series of processes with respect to the substrate SB in a substantially vacuum state until a plurality of elements, electric and electronic circuits formed from them, and the like are formed on the substrate SB, that is, until a desired electronic device is manufactured.

An organic light emitting device that can be manufactured using the film forming apparatus FF or the processing system SY will be exemplarily described below.

### [Arrangement of Organic Light Emitting Device]

The organic light emitting device is provided by forming an insulating layer, a first electrode, an organic compound layer, and a second electrode on a substrate. A protection layer, a color filter, a microlens, and the like may be provided on a cathode. If a color filter is provided, a planarizing layer can be provided between the protection layer and the color filter. The planarizing layer can be made of acrylic resin or the like. The same applies to a case in which a planarizing layer is provided between the color filter and the microlens.

### [Substrate]

Quartz, glass, a silicon wafer, a resin, a metal, or the like may be used as a substrate. Furthermore, a switching element such as a transistor and a wiring may be provided on the substrate, and an insulating layer may be provided thereon. The insulating layer may be made of any material as long as a contact hole can be formed so that the wiring can be formed between the insulating layer and the first electrode and insulation from the unconnected wiring can be ensured. For example, a resin such as polyimide, silicon oxide, silicon nitride, or the like can be used.

### [Electrode]

A pair of electrodes can be used as the electrodes. The pair of electrodes can be an anode and a cathode. If an electric field is applied in the direction in which the organic light emitting device emits light, the electrode having a high potential is the anode, and the other is the cathode. It can also be said that the electrode that supplies holes to the light emitting layer is the anode and the electrode that supplies electrons is the cathode.

As the constituent material of the anode, a material having a work function as large as possible is preferably used. For example, a metal such as gold, platinum, silver, copper, nickel, palladium, cobalt, selenium, vanadium, or tungsten can be used. Alternatively, a mixture containing some of them, an alloy obtained by combining some of them, or a metal oxide such as tin oxide, zinc oxide, indium oxide, indium tin oxide (ITO), or zinc indium oxide can be used. Furthermore, a conductive polymer such as polyaniline, polypyrrole, or polythiophene can also be used.

One of these electrode materials may be used singly, or two or more of them may be used in combination. The anode may be formed by a single layer or a plurality of layers.

If the anode is used as a reflective electrode, for example, chromium, aluminum, silver, titanium, tungsten, molybdenum, an alloy thereof, a stacked layer thereof, or the like can be used. The above materials can function as a reflective film having no role as an electrode. If the anode is used as a transparent electrode, an oxide transparent conductive layer made of indium tin oxide (ITO), indium zinc oxide, or the like can be used, but the present invention is not limited thereto. A photolithography technique can be used to form the electrode.

On the other hand, as the constituent material of the cathode, a material having a small work function is preferably used. Examples of the material include an alkali metal such as lithium, an alkaline earth metal such as calcium, a metal such as aluminum, titanium, manganese, silver, lead, or chromium, and a mixture containing some of them. Alternatively, an alloy obtained by combining these metals can also be used. For example, a magnesium-silver alloy, an aluminum-lithium alloy, an aluminum-magnesium alloy, a silver-copper alloy, a zinc-silver alloy, or the like can be used. A metal oxide such as indium tin oxide (ITO) can also be used. One of these electrode materials may be used singly, or two or more of them may be used in combination. The cathode may have a single-layer structure or a multilayer structure. Among others, silver is preferably used. To suppress aggregation of silver, a silver alloy is more preferably used. The ratio of the alloy is not limited as long as aggregation of silver can be suppressed. For example, the ratio between silver and another metal may be 1 : 1, 3 : 1, or the like.

The cathode may be a top emission device using an oxide conductive layer made of ITO or the like, or may be a bottom emission device using a reflective electrode made of aluminum (Al) or the like, and is not particularly limited. The method of forming the cathode is not particularly limited, but direct current sputtering or alternating current sputtering is preferably used since the good film coverage is provided and the resistance is easily lowered.

### [Pixel Isolation Layer]

A pixel isolation layer is formed by a silicon nitride (SiN) film, a silicon oxynitride (SiON) film, or a silicon oxide (SiO) film formed using a Chemical Vapor Deposition method (CVD method). To increase the resistance in the in-plane direction of the organic compound layer, the organic compound layer, especially the hole transport layer is preferably thinly deposited on the side wall of the pixel isolation layer. More specifically, the organic compound layer can be deposited so as to have a thin film thickness on the side wall by increasing the taper angle of the side wall of the pixel isolation layer or the film thickness of the pixel isolation layer to increase vignetting during vapor deposition.

On the other hand, it is preferable to adjust the taper angle of the side wall of the pixel isolation layer or the film thickness of the pixel isolation layer to the extent that no space is formed in the protection layer formed on the pixel isolation layer. Since no space is formed in the protection layer, it is possible to reduce generation of defects in the protection layer. Since generation of detects in the protection layer is reduced, a decrease in reliability caused by generation of a dark spot or occurrence of a conductive failure of the second electrode can be reduced.

According to this embodiment, even if the taper angle of the side wall of the pixel isolation layer is not acute, it is possible to effectively suppress leakage of charges to an adjacent pixel. As a result of this consideration, it has been found that the taper angle of 60° (inclusive) to 90° (inclusive) can sufficiently reduce the occurrence of defects. The film thickness of the pixel isolation layer is desirably 10 nm (inclusive) to 150 nm (inclusive). A similar effect can be obtained in an arrangement including only pixel electrodes without the pixel isolation layer. However, in this case, the film thickness of the pixel electrode is preferably set to be equal to or smaller than half the film thickness of the organic layer or the end portion of the pixel electrode is preferably formed to have a forward tapered shape of less than 60° because short circuit of the organic light emitting device can be reduced.

### [Organic Compound Layer]

The organic compound layer may be formed by a single layer or a plurality of layers. If the organic compound layer includes a plurality of layers, the layers can be called a hole injection layer, a hole transport layer, an electron blocking layer, a light emitting layer, a hole blocking layer, an electron transport layer, and an electron injection layer in accordance with the functions of the layers. The organic compound layer is mainly formed from an organic compound but may contain inorganic atoms and an inorganic compound. For example, the organic compound layer may contain copper, lithium, magnesium, aluminum, iridium, platinum, molybdenum, zinc, or the like. The organic compound layer may be arranged between the first and second electrodes, and may be arranged in contact with the first and second electrodes.

### [Protection Layer]

A protection layer may be provided on the second electrode. For example, by adhering glass provided with a moisture absorbing agent on the second electrode, permeation of water or the like into the organic compound layer can be suppressed and occurrence of display defects can be suppressed. Furthermore, as another embodiment, a passivation film made of silicon nitride or the like may be provided on the cathode to suppress permeation of water or the like into the organic compound layer. For example, the protection layer can be formed by forming the cathode, transferring it to another chamber without breaking the vacuum, and forming a silicon nitride film having a thickness of 2 µm by the CVD method. The protection layer may be provided using an atomic deposition method (ALD method) after deposition using the CVD method. The material of the film by the ALD method is not limited but can be silicon nitride, silicon oxide, aluminum oxide, or the like. A silicon nitride film may further be formed by the CVD method on the film formed by the ALD method. The film formed by the ALD method may have a film thickness smaller than that of the film formed by the CVD method. More specifically, the film thickness of the film formed by the ALD method may be 50% or less, or 10% or less.

### [Color Filter]

A color filter may be provided on the protection layer. For example, a color filter considering the size of the organic light emitting device may be provided on another substrate, and this substrate may be bonded to the substrate with the organic light emitting device provided thereon. Alternatively, a color filter may be patterned on the above-described protection layer using a photolithography technique. The color filter can be formed from a polymeric material.

### [Planarizing Layer]

A planarizing layer may be provided between the color filter and the protection layer. The planarizing layer is provided to reduce unevenness of the lower layer. The planarizing layer may be called a material resin layer without limiting the purpose of the layer. The planarizing layer can be formed from an organic compound, and can be made of a low-molecular material or a polymeric material. However, a polymetric material is more preferable.

The planarizing layers may be provided above and below the color filter, and the same or different materials may be used for them. More specifically, examples of the material include polyvinyl carbazole resin, polycarbonate resin, polyester resin, ABS resin, acrylic resin, polyimide resin, phenol resin, epoxy resin, silicone resin, and urea resin.

### [Microlens]

The organic light emitting apparatus can include an optical member such as a microlens on the light emission side. The microlens can be made of acrylic resin, epoxy resin, or the like. The microlens can aim to increase the amount of light extracted from the organic light emitting apparatus and control the direction of light to be extracted. The microlens can have a hemispherical shape. If the microlens has a hemispherical shape, among tangents contacting the hemisphere, there is a tangent parallel to the insulating layer, and the contact between the tangent and the hemisphere is the vertex of the microlens. The vertex of the microlens can be decided in the same manner even in an arbitrary sectional view. That is, among tangents contacting the semicircle of the microlens in a sectional view, there is a tangent parallel to the insulating layer, and the contact between the tangent and the semicircle is the vertex of the microlens.

Furthermore, the middle point of the microlens can also be defined. In the section of the microlens, a line segment from a point at which an arc shape ends to a point at which another arc shape ends is assumed, and the middle point of the line segment can be called the middle point of the microlens. A section for determining the vertex and the middle point may be a section perpendicular to the insulating layer.

The microlens includes a first surface including a convex portion and a second surface opposite to the first surface. The second surface is preferably arranged on the functional layer side of the first surface. For this arrangement, the microlens needs to be formed on the light emitting apparatus. If the functional layer is an organic layer, it is preferable to avoid a process which produces high temperature in the manufacturing step. In addition, if it is configured to arrange the second surface on the functional layer side of the first surface, all the glass transition temperatures of an organic compound forming the organic layer are preferably 100°C or more, and more preferably 130°C or more.

### [Counter Substrate]

A counter substrate can be provided on the planarizing layer. The counter substrate is called a counter substrate because it is provided at a position corresponding to the above-described substrate. The constituent material of the counter substrate can be the same as that of the above-described substrate. If the above-described substrate is the first substrate, the counter substrate can be the second substrate.

### [Organic Layer]

The organic compound layer (hole injection layer, hole transport layer, electron blocking layer, light emitting layer, hole blocking layer, electron transport layer, electron injection layer, and the like) forming the organic light emitting device according to an embodiment of the present invention is formed by the method to be described below.

The organic compound layer forming the organic light emitting device according to the embodiment of the present invention can be formed by a dry process using a vacuum deposition method, an ionization deposition method, a sputtering method, a plasma method, or the like. Instead of the dry process, a wet process that forms a layer by dissolving a solute in an appropriate solvent and using a well-known coating method (for example, a spin coating method, a dipping method, a casting method, an LB method, an inkjet method, or the like) can be used.

Here, when the layer is formed by a vacuum deposition method, a solution coating method, or the like, crystallization or the like hardly occurs and excellent temporal stability is obtained. Furthermore, when the layer is formed using a coating method, it is possible to form the film in combination with a suitable binder resin.

Examples of the binder resin include polyvinyl carbazole resin, polycarbonate resin, polyester resin, ABS resin, acrylic resin, polyimide resin, phenol resin, epoxy resin, silicone resin, and urea resin. However, the binder resin is not limited to them.

One of these binder resins may be used singly as a homopolymer or a copolymer, or two or more of them may be used in combination. Furthermore, additives such as a well-known plasticizer, antioxidant, and an ultraviolet absorber may also be used as needed.

### [Pixel Circuit]

The light emitting apparatus can include a pixel circuit connected to the light emitting device. The pixel circuit may be an active matrix circuit that individually controls light emission of the first and second light emitting devices. The active matrix circuit may be a voltage or current programing circuit. A driving circuit includes a pixel circuit for each pixel. The pixel circuit can include a light emitting device, a transistor for controlling light emission luminance of the light emitting device, a transistor for controlling a light emission timing, a capacitor for holding the gate voltage of the transistor for controlling the light emission luminance, and a transistor for connection to GND without intervention of the light emitting device.

The light emitting apparatus includes a display region and a peripheral region arranged around the display region. The light emitting apparatus includes the pixel circuit in the display region and a display control circuit in the peripheral region. The mobility of the transistor forming the pixel circuit may be smaller than that of a transistor forming the display control circuit.

The slope of the current-voltage characteristic of the transistor forming the pixel circuit may be smaller than that of the current-voltage characteristic of the transistor forming the display control circuit. The slope of the current-voltage characteristic can be measured by a so-called Vg-Ig characteristic.

The transistor forming the pixel circuit is a transistor connected to the light emitting device such as the first light emitting device.

### [Pixel]

The organic light emitting apparatus includes a plurality of pixels. Each pixel includes sub-pixels that emit light components of different colors. The sub-pixels include, for example, R, G, and B emission colors, respectively.

In each pixel, a region also called a pixel opening emits light. This region is the same as the first region. The pixel opening can have a size of 5 µm (inclusive) to 15 µm (inclusive). More specifically, the pixel opening can have a size of 11 µm, 9.5 µm, 7.4 µm, 6.4 µm, or the like.

A distance between the sub-pixels can be 10 µm or less, and can be, more specifically, 8 µm, 7.4 µm, or 6.4 µm.

The pixels can have a known arrangement form in a plan view. For example, the pixels may have a stripe arrangement, a delta arrangement, a pentile arrangement, or a Bayer arrangement. The shape of each sub-pixel in a plan view may be any known shape. For example, a quadrangle such as a rectangle or a rhombus, a hexagon, or the like may be possible. A shape which is not a correct shape but is close to a rectangle is included in a rectangle, as a matter of course. The shape of the sub-pixel and the pixel arrangement can be used in combination.

### [Application of Organic Light Emitting Device]

The organic light emitting device can be used as a constituent member of a display apparatus or an illumination apparatus. In addition, the organic light emitting device is applicable to the exposure light source of an electrophotographic image forming apparatus, the backlight of a liquid crystal display apparatus, a light emitting apparatus including a color filter in a white light source, and the like.

The display apparatus may be an image information processing apparatus that includes an image input unit for inputting image information from an area CCD, a linear CCD, a memory card, or the like, and an information processing unit for processing the input information, and displays the input image on a display unit.

In addition, a display unit included in an image capturing apparatus or an inkjet printer can have a touch panel function. The driving type of the touch panel function may be an infrared type, a capacitance type, a resistive film type, or an electromagnetic induction type, and is not particularly limited. The display apparatus may be used for the display unit of a multifunction printer.

Next, application examples of the organic light emitting device will be described.

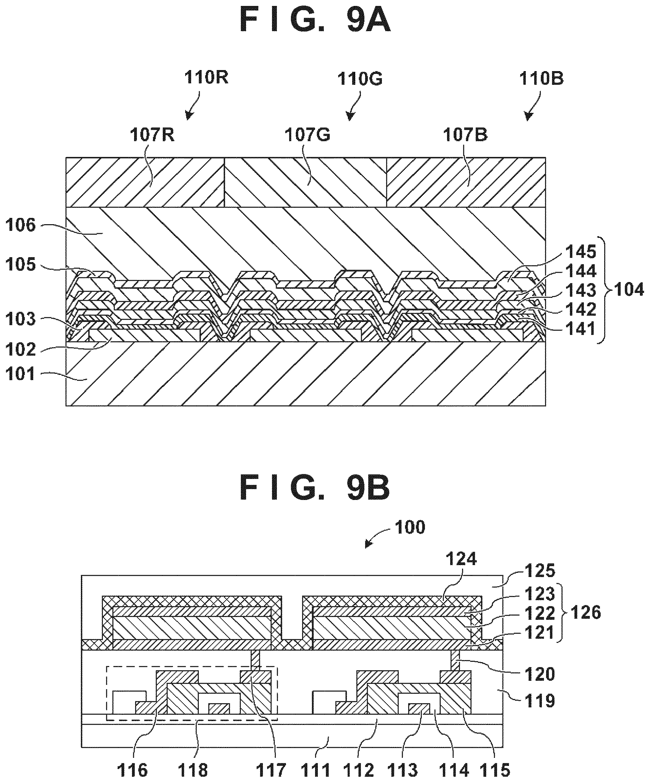

Figs. 9A and 9B are schematic sectional views showing an example of a display apparatus including an organic light emitting device and a transistor connected thereto. The transistor is an example of an active device. The transistor may be a thin-film transistor (TFT).

Fig. 9A is a view exemplarily showing the arrangement of a pixel as a constituent element of the display apparatus. The pixel includes sub-pixels 110. The sub-pixels are divided into sub-pixels 110R, 110G, and 110B by emitted light components. The light emission colors may be discriminated by the wavelengths of light components emitted from the light emitting layers, or light emitted from each sub-pixel may be selectively transmitted or undergo color conversion by a color filter or the like. Each sub-pixel includes a reflective electrode 102 as the first electrode on an interlayer insulating layer 101, an insulating layer 103 covering the end of the reflective electrode 102, an organic compound layer 104 covering the first electrode and the insulating layer, a second electrode 105, a protection layer 106, and a color filter 107.

The interlayer insulating layer 101 can include a transistor and a capacitive element arranged in the interlayer insulating layer 101 or a layer below it. The transistor and the first electrode can electrically be connected via a contact hole (not shown) or the like. The insulating layer 103 is also called a bank or a pixel isolation film. The insulating layer 103 covers the end of the first electrode, and is arranged to surround the first electrode. A portion where no insulating layer is arranged is in contact with the organic compound layer 104 to form a light emitting region. The organic compound layer 104 includes a hole injection layer 141, a hole transport layer 142, a first light emitting layer 143, a second light emitting layer 144, and an electron transport layer 145. The second electrode 105 may be a transparent electrode, a reflective electrode, or a semi-transmissive electrode.

The protection layer 106 suppresses permeation of water into the organic compound layer. The protection layer is shown as a single layer but may include a plurality of layers. Each layer can be an inorganic compound layer or an organic compound layer. The color filter 107 is divided into color filters 107R, 107G, and 107B by colors. The color filters can be formed on a planarizing film (not shown). A resin protection layer (not shown) can be provided on the color filters. The color filters can be formed on the protection layer 106. Alternatively, the color filters can be provided on the counter substrate such as a glass substrate, and then the substrate may be bonded.

A display apparatus 100 shown in Fig. 9B is provided with an organic light emitting device 126 and a TFT 118 as an example of a transistor. A substrate 111 of glass, silicon, or the like is provided and an insulating layer 112 is provided on the substrate 111. The active element such as the TFT 118 is arranged on the insulating layer, and a gate electrode 113, a gate insulating film 114, and a semiconductor layer 115 of the active element are arranged. The TFT 118 further includes the semiconductor layer 115, a drain electrode 116, and a source electrode 117. An insulating film 119 is provided on the TFT 118. The source electrode 117 and an anode 121 forming the organic light emitting device 126 are connected via a contact hole 120 formed in the insulating film.

Note that a method of electrically connecting the electrodes (anode and cathode) included in the organic light emitting device 126 and the electrodes (source electrode and drain electrode) included in the TFT is not limited to that shown in Fig. 9B. That is, one of the anode and cathode and one of the source electrode and drain electrode of the TFT are electrically connected. The TFT indicates a thin-film transistor.

In Fig. 9B, the organic compound layer of the display apparatus 100 is illustrated as one layer. However, an organic compound layer 122 may be formed by a plurality of layers. A first protection layer 124 and a second protection layer 125 are provided on a cathode 123 to suppress deterioration of the organic light emitting device. In Fig. 9B, a transistor is used as a switching element of the display apparatus 100, but the transistor may be used as another switching element.

The transistor used in the display apparatus 100 shown in Fig. 9B is not limited to a transistor using a single-crystal silicon wafer, and may be a thin-film transistor including an active layer on an insulating surface of a substrate. Examples of the active layer include single-crystal silicon, amorphous silicon, non-single-crystal silicon such as microcrystalline silicon, and a non-single-crystal oxide semiconductor such as indium zinc oxide and indium gallium zinc oxide. Note that a thin-film transistor is also called a TFT element.

The transistor included in the display apparatus 100 shown in Fig. 9B may be formed in the substrate such as an Si substrate. Forming the transistor in the substrate means forming the transistor by processing the substrate such as an Si substrate. That is, when the transistor is included in the substrate, it can be considered that the substrate and the transistor are formed integrally.

The light emission luminance of the organic light emitting device can be controlled by the TFT which is an example of a switching element, and the plurality of organic light emitting devices can be provided in a plane to display an image with the light emission luminances of the respective devices. Note that the switching element according to this embodiment is not limited to the TFT, and may be a transistor formed from low-temperature polysilicon or an active matrix driver formed on the substrate such as an Si substrate. The term "on the substrate" may mean "in the substrate". Whether to provide a transistor in the substrate or use a TFT is selected based on the size of the display unit. For example, if the size is about 0.5 inch, the organic light emitting device is preferably provided on the Si substrate.

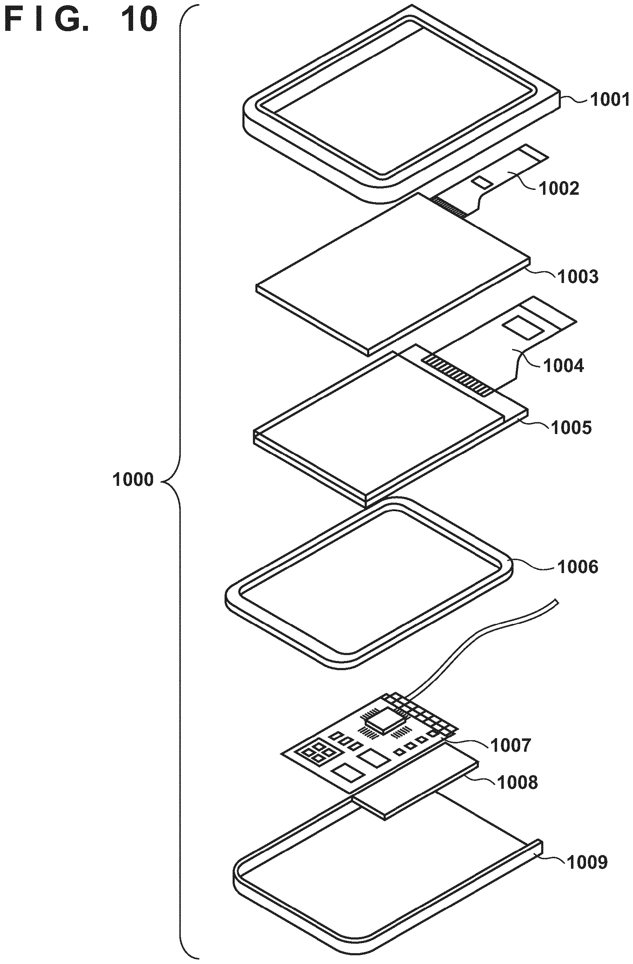

Fig. 10 is a schematic view showing an example of a display apparatus 1000 according to an embodiment. The display apparatus 1000 can include a touch panel 1003, a display panel 1005, a frame 1006, a circuit board 1007, and a battery 1008 between an upper cover 1001 and a lower cover 1009. Flexible printed circuits (FPCs) 1002 and 1004 are respectively connected to the touch panel 1003 and the display panel 1005. Transistors are printed on the circuit board 1007. The battery 1008 is unnecessary if the display apparatus is not portable equipment. Even when the display apparatus is portable equipment, the battery 1008 may be provided at another position.

The display apparatus 1000 can include color filters of red, green, and blue. The color filters of red, green, and blue can be arranged in a delta array. The display apparatus 1000 can also be used for a display unit of a portable terminal. At this time, the display unit can have both a display function and an operation function. Examples of the portable terminal are a portable phone such as a smartphone, a tablet, and a head mounted display.

The display apparatus 1000 can be used for a display unit of an image capturing apparatus including an optical unit including a plurality of lenses, and an image sensor for receiving light having passed through the optical unit. The image capturing apparatus can include a display unit for displaying information acquired by the image sensor. In addition, the display unit can be either a display unit exposed outside the image capturing apparatus, or a display unit arranged in the finder. The image capturing apparatus can be a digital camera or a digital video camera.

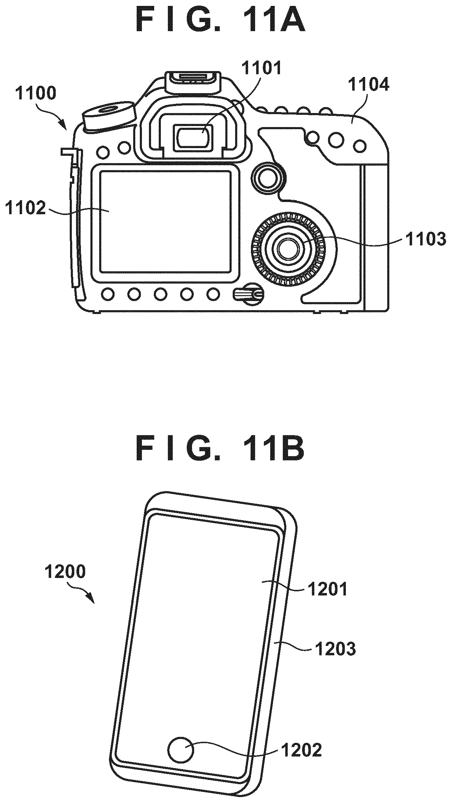

Fig. 11A is a schematic view showing an example of the image capturing apparatus according to the embodiment. An image capturing apparatus 1100 can include a viewfinder 1101, a rear display 1102, an operation unit 1103, and a housing 1104. The viewfinder 1101 may include the display apparatus described above. In this case, the display apparatus can display not only an image to be captured but also environment information, image capturing instructions, and the like. Examples of the environment information are the intensity and direction of external light, the moving velocity of an object, and the possibility that an object is covered with an obstacle.

The timing suitable for image capturing is a very short time, so the information is preferably displayed as soon as possible. Therefore, the display apparatus using the organic light emitting device of the present invention is preferably used. This is so because the organic light emitting device has a high response speed. The display apparatus using the organic light emitting device can be used for the apparatuses that require a high display speed more preferably than for the liquid crystal display apparatus.

The image capturing apparatus 1100 includes an optical unit (not shown). This optical unit includes a plurality of lenses, and forms an image on an image sensor that is accommodated in the housing 1104. The focal points of the plurality of lenses can be adjusted by adjusting the relative positions. This operation can also automatically be performed. The image capturing apparatus may be called a photoelectric conversion apparatus. Instead of sequentially capturing an image, the photoelectric conversion apparatus can include, as an image capturing method, a method of detecting the difference from a previous image, a method of extracting an image from an always recorded image, or the like.

Fig. 11B is a schematic view showing an example of electronic equipment according to the embodiment. Electronic equipment 1200 includes a display unit 1201, an operation unit 1202, and a housing 1203. The housing 1203 can accommodate a circuit, a printed board including this circuit, a battery, and a communication unit. The operation unit 1202 may be a button or a touch-panel-type reaction unit. The operation unit may also be a biometric authentication unit that performs unlocking or the like by authenticating a fingerprint. The electronic equipment including the communication unit can also be regarded as communication equipment. The electronic equipment can further have a camera function by including a lens and an image sensor. An image captured by the camera function is displayed on the display unit. Examples of the electronic equipment are a smartphone and a laptop computer.

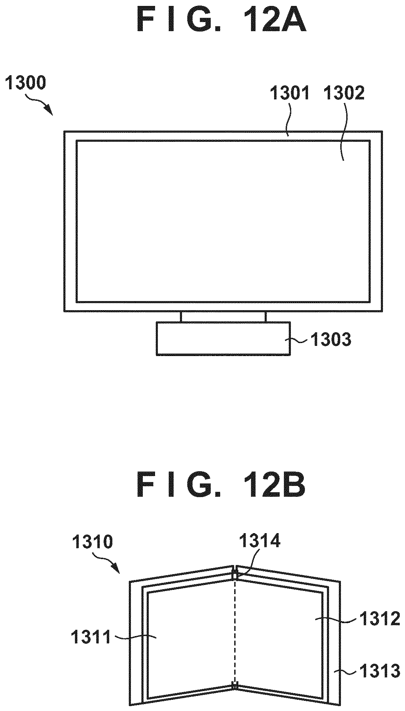

Fig. 12A is a schematic view showing one example of the display apparatus according to an embodiment. Fig. 12A shows a display apparatus such as a television monitor or a PC monitor. A display apparatus 1300 includes a frame 1301 and a display unit 1302. The light emitting apparatus described above may be used in the display unit 1302. The display apparatus 1300 includes a base 1303 that supports the frame 1301 and the display unit 1302. The base 1303 is not limited to the form shown in Fig. 12A. The lower side of the frame 1301 may also function as the base. In addition, the frame 1301 and the display unit 1302 may be bent. The radius of curvature can be 5,000 mm (inclusive) to 6,000 mm (inclusive).

Fig. 12B is a schematic view showing another example of the display apparatus according to an embodiment. A display apparatus 1310 shown in Fig. 12B is configured to be foldable, that is, the display apparatus 1310 is a so-called foldable display apparatus. The display apparatus 1310 includes a first display unit 1311, a second display unit 1312, a housing 1313, and a bending point 1314. Each of the first display unit 1311 and the second display unit 1312 may include the light emitting apparatus according to the embodiment. The first display unit 1311 and the second display unit 1312 may be one seamless display apparatus. The first display unit 1311 and the second display unit 1312 can be divided by the bending point. The first display unit 1311 and the second display unit 1312 can display different images, and can also display one image together.

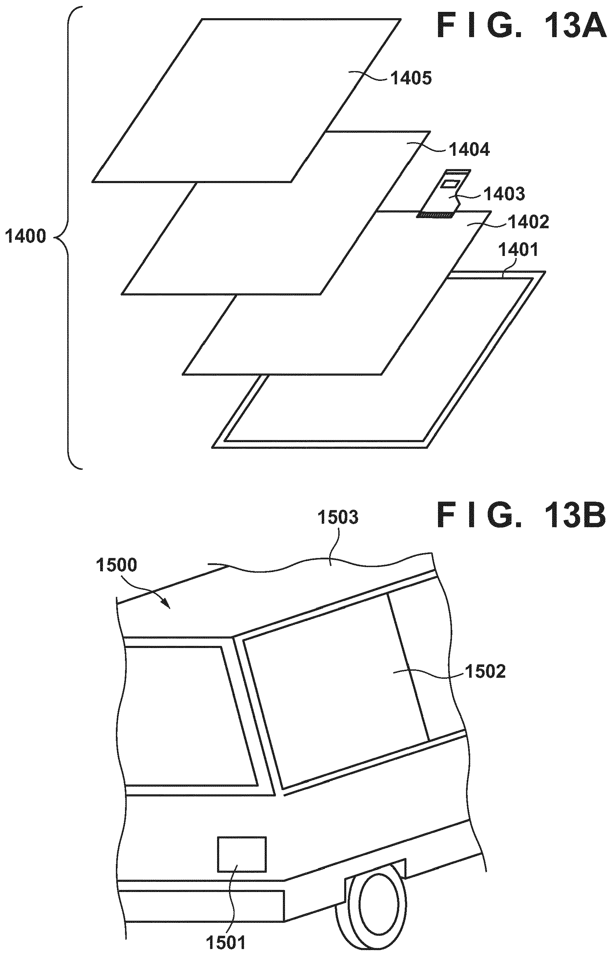

Fig. 13A is a schematic view showing an example of an illumination apparatus according to an embodiment. An illumination apparatus 1400 can include a housing 1401, a light source 1402, a circuit board 1403, an optical film 1404, and a light-diffusing unit 1405. The light source may include the organic light emitting device according to the embodiment. The optical filter can be a filter that improves the color rendering of the light source. When performing lighting-up or the like, the light-diffusing unit can throw the light of the light source over a broad range by effectively diffusing the light. The optical filter and the light-diffusing unit can be provided on the illumination light emission side. The illumination apparatus can also include a cover on the outermost portion, as needed.

The illumination apparatus is, for example, an apparatus for illuminating the interior of the room. The illumination apparatus may emit white light, natural white light, or light of any color from blue to red. The illumination apparatus can also include a light control circuit for controlling these light components. The illumination apparatus can also include the organic light emitting device according to the present invention and a power supply circuit connected to the organic light emitting device. The power supply circuit is a circuit for converting an AC voltage into a DC voltage. White has a color temperature of 4,200 K, and natural white has a color temperature of 5,000 K. The illumination apparatus may also include a color filter.

In addition, the illumination apparatus according to the embodiment may include a heat radiation unit. The heat radiation unit radiates the internal heat of the apparatus to the outside of the apparatus, and examples are a metal having a high specific heat and liquid silicon.

Fig. 13B is a schematic view of an automobile as an example of a moving body according to an embodiment. The automobile includes a taillight as an example of the lighting appliance. An automobile 1500 includes a taillight 1501, and can have a form in which the taillight is turned on when performing a braking operation or the like.

The taillight 1501 may include the organic light emitting device according to the embodiment. The taillight can include a protection member for protecting the organic EL device. The material of the protection member is not limited as long as the material is a transparent material with a strength that is high to some extent, and is preferably polycarbonate. A furandicarboxylic acid derivative, an acrylonitrile derivative, or the like may be mixed in polycarbonate.

The automobile 1500 can include a vehicle body 1503, and a window 1502 attached to the vehicle body 1503. This window may be a window for checking the front and back of the automobile, and can also be a transparent display. This transparent display can include the organic light emitting device according to the embodiment. In this case, the constituent materials of the electrodes and the like of the organic light emitting device are formed by transparent members.

The moving body according to this embodiment can be a ship, an airplane, a drone, or the like. The moving body can include a main body and a lighting appliance provided on the main body. The lighting appliance can emit light for making a notification of the position of the main body. The lighting appliance includes the organic light emitting device according to the embodiment.

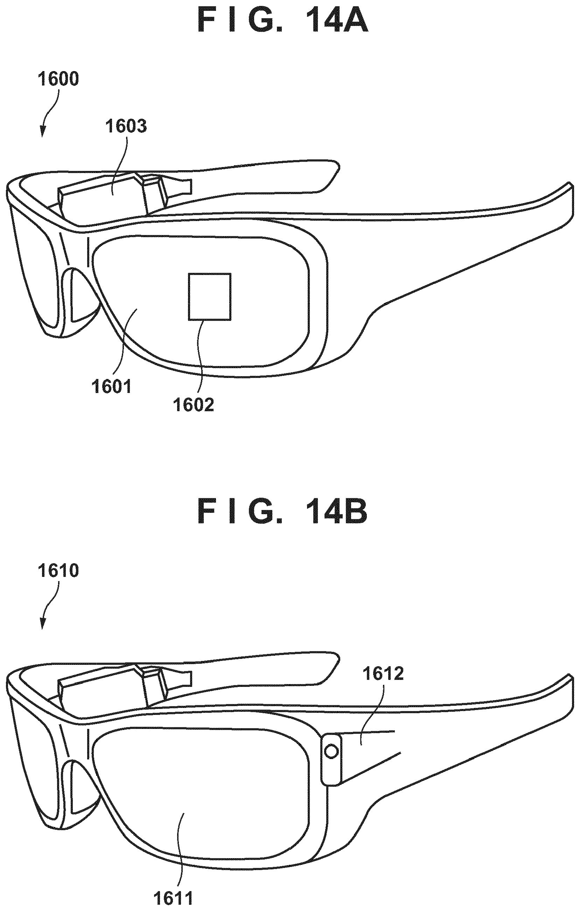

Application examples of various kinds of display apparatuses described above will be described with reference to Figs. 14A and 14B. The display apparatus can be applied to a system that can be worn as a wearable device such as smartglasses, an HMD, or a smart contact lens. An image capturing apparatus device used in such an application example includes an image capturing apparatus capable of photoelectrically converting visible light and a display apparatus capable of emitting visible light.

Glasses 1600 (smartglasses) according to one application example will be described with reference to Fig. 14A. An image capturing apparatus 1602 such as a CMOS sensor or an SPAD is provided on the front surface side of a lens 1601 of the glasses 1600. In addition, the display apparatus of each of the above-described embodiments is provided on the back surface side of the lens 1601.

The glasses 1600 further include a control apparatus 1603. The control apparatus 1603 functions as a power supply that supplies power to the image capturing apparatus 1602 and the display apparatus according to each embodiment. In addition, the control apparatus 1603 controls the operations of the image capturing apparatus 1602 and the display apparatus. An optical system configured to condense light to the image capturing apparatus 1602 is formed on the lens 1601.

Glasses 1610 (smartglasses) according to one application example will be described with reference to Fig. 14B. The glasses 1610 includes a control apparatus 1612. An image capturing apparatus corresponding to the image capturing apparatus 1602 and a display apparatus are mounted on the control apparatus 1612. An optical system configured to project light emitted by the display apparatus in the control apparatus 1612 is formed in a lens 1611, and an image is projected to the lens 1611. The control apparatus 1612 functions as a power supply that supplies power to the image capturing apparatus and the display apparatus, and controls the operations of the image capturing apparatus and the display apparatus. The control apparatus may include a line-of-sight detection unit that detects the line of sight of a wearer. The detection of a line of sight may be done using infrared rays. An infrared ray emitting unit emits infrared rays to an eyeball of the user who is gazing at a displayed image. An image capturing unit including a light receiving element detects reflected light of the emitted infrared rays from the eyeball, thereby obtaining a captured image of the eyeball. A reduction unit for reducing light from the infrared ray emitting unit to the display unit in a planar view is provided, thereby reducing deterioration of image quality.

The line of sight of the user to the displayed image is detected from the captured image of the eyeball obtained by capturing the infrared rays. An arbitrary known method can be applied to the line-of-sight detection using the captured image of the eyeball. As an example, a line-of-sight detection method based on a Purkinje image obtained by reflection of irradiation light by a cornea can be used.

More specifically, line-of-sight detection processing based on pupil center corneal reflection is performed. Using pupil center corneal reflection, a line-of-sight vector representing the direction (rotation angle) of the eyeball is calculated based on the image of the pupil and the Purkinje image included in the captured image of the eyeball, thereby detecting the line-of-sight of the user.

The display apparatus according to the embodiment of the present invention may include an image capturing apparatus including a light receiving element, and a displayed image on the display apparatus may be controlled based on the line-of-sight information of the user from the image capturing apparatus.

More specifically, the display apparatus decides a first display region at which the user is gazing and a second display region other than the first display region based on the line-of-sight information. The first display region and the second display region may be decided by the control apparatus of the display apparatus, or those decided by an external control apparatus may be received. In the display region of the display apparatus, the display resolution of the first display region may be controlled to be higher than the display resolution of the second display region. That is, the resolution of the second display region may be lower than that of the first display region.

In addition, the display region includes a first display region and a second display region different from the first display region, and a region of higher priority is decided from the first display region and the second display region based on line-of-sight information. The first display region and the second display region may be decided by the control apparatus of the display apparatus, or those decided by an external control apparatus may be received. The resolution of the region of higher priority may be controlled to be higher than the resolution of the region other than the region of higher priority. That is, the resolution of the region of relatively low priority may be low.

Note that Al may be used to decide the first display region or the region of higher priority. The AI may be a model configured to estimate the angle of the line of sight and the distance to a target ahead the line of sight from the image of the eyeball using the image of the eyeball and the direction of actual viewing of the eyeball in the image as supervised data. The Al program may be held by the display apparatus, the image capturing apparatus, or an external apparatus. If the external apparatus holds the Al program, it is transmitted to the display apparatus via communication.

When performing display control based on line-of-sight detection, smartglasses further including an image capturing apparatus configured to capture the outside can preferably be applied. The smartglasses can display captured outside information in real time.

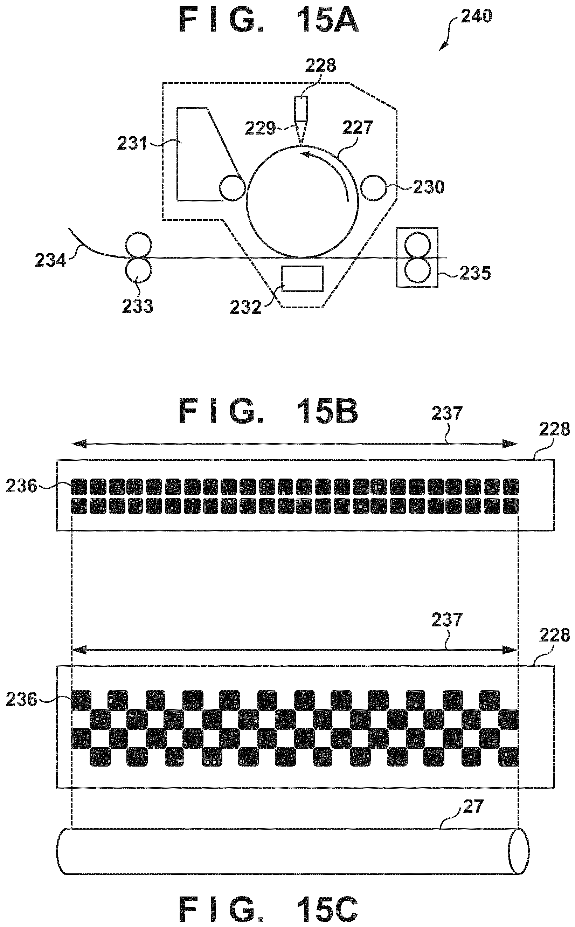

Figs. 15A to 15C show an image forming apparatus according to an embodiment. Fig. 15A is a schematic view of an image forming apparatus 240 according to an embodiment. The image forming apparatus includes a photosensitive member, an exposure light source, a developing unit, a charging unit, a transfer device, a conveyance roller, and a fixing device.

Light 229 is emitted from the exposure light source 228, and an electrostatic latent image is formed on the surface of a photosensitive member 227. The exposure light source includes the organic light emitting device according to the present invention. A developing unit 231 includes a toner. A charging unit 230 charges the photosensitive member. A transfer device 232 transfers the developed image to a print medium 234. A conveyance unit 233 conveys the print medium 234. The print medium 234 can be, for example, paper. A fixing device 235 fixes the image formed on the print medium.

Each of Figs. 15B and 15C is a schematic view showing a form in which a plurality of light emitting portions 238 are arranged in an exposure light source 228 on a long substrate. Reference numeral 237 denotes a direction parallel to the axis of the photosensitive member, which represents a column direction in which organic light emitting devices are arrayed. This column direction matches the direction of the axis upon rotating the photosensitive member 227. This direction can also be referred to as the long-axis direction of the photosensitive member.

Fig. 15B shows a form in which the light emitting portions are arranged along the long-axis direction of the photosensitive member. Fig. 15C shows a form which is different from that shown in Fig. 15B and in which the light emitting portions are arranged in the column direction alternately between the first column and the second column. The light emitting portions are arranged at different positions in the row direction between the first column and the second column.

In the first column, the plurality of light emitting portions are arranged apart from each other. In the second column, the light emitting portion is arranged at the position corresponding to the space between the light emitting portions in the first column. That is, in the row direction as well, the plurality of light emitting portions are arranged apart from each other.

The arrangement shown in Fig. 15C can be referred to as, for example, an arrangement in a grid pattern, an arrangement in a staggered pattern, or an arrangement in a checkered pattern.

As has been described above, by using the apparatus using the organic light emitting device according to the embodiment, display with fine image quality and stable even for a long period of time is possible.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. A film forming apparatus comprising:
an outer chamber;
an inner chamber arranged inside the outer chamber and dividable into a first portion and a second portion;
a driving mechanism configured to lift and lower the second portion along an elevator axis; and
a plurality of supply paths arranged so as to be capable of individually supplying a plurality of source gases to a first space which is a space inside the inner chamber,
wherein
the first portion includes a first seal, and the second portion includes a second seal to come into contact with the first seal, and
in a longitudinal section along a plane including the elevator axis, a surface of each of the first seal and the second seal has a non-linear shape.

2. The apparatus according to claim 1, wherein
the driving mechanism is configured to be capable of driving the second portion to a first position where a first state is set, in which the first seal and the second seal are in contact with each other, and driving the second portion to a second position where a second state is set, in which the first seal and the second seal are separated from each other.

3. The apparatus according to claim 2, wherein
the first seal and the second seal form, in the first state, a seal mechanism configured to insulate a second space, which is a space inside the outer chamber and outside the inner chamber, from the first space.

4. The apparatus according to claim 2 or 3, wherein
in the longitudinal section, one of the first seal and the second seal includes a concave shape part, and the other of the first seal and the second seal includes a convex shape part.

5. The apparatus according to claim 4, wherein
each of the first seal and the second seal has a frame shape in a transverse section along a plane orthogonal to the elevator axis.

6. The apparatus according to any one of claims 2 to 5, wherein
in the first state, the first seal and the second seal are in line contact with each other.

7. The apparatus according to any one of claims 2 to 6, wherein
in the first state, a contact portion between the first seal and the second seal forms a closed shape.

8. The apparatus according to claim 4, wherein
the concave shape part is formed as a triangular notch in the longitudinal section, and the convex shape part has a triangular shape in the longitudinal section.

9. The apparatus according to claim 4, wherein
the concave shape part is formed as a triangular notch in the longitudinal section, and the convex shape part includes a portion formed by a part of one of a circle and an ellipse in the longitudinal section.

10. The apparatus according to claim 4, wherein
the concave shape part includes a portion formed by a part of one of a circle and an ellipse in the longitudinal section, and the convex shape part includes a portion formed by a part of one of a circle and an ellipse in the longitudinal section.

11. The apparatus according to claim 4, wherein
the concave shape part is formed as a trapezoidal notch in the longitudinal section, and the convex shape part has a trapezoidal shape in the longitudinal section.

12. The apparatus according to claim 2 or 3, wherein
in the longitudinal section, one of the first seal and the second seal includes a plurality of concave shape parts, and the other of the first seal and the second seal includes a plurality of convex shape parts.

13. The apparatus according to claim 2, wherein
in the longitudinal section, one of the first seal and the second seal includes a first concave part and a first convex part, and the other of the first seal and the second seal includes a second convex part facing the first concave part, and a second concave part facing the first convex part.

14. The apparatus according to any one of claims 1 to 13, wherein
the apparatus is configured to form a film by an atomic layer deposition method.

15. A method of manufacturing an electronic device comprising:
forming a film on a substrate by a film forming apparatus defined in claim 14; and
obtaining the electronic device by processing the substrate with the film formed thereon.

16. The method according to claim 15, wherein
the electronic device includes an organic light emitting device.
